# EUROPEAN PATENT APPLICATION

(11) **EP 4 752 671 A1**
(43) Date of publication of application: **03.06.2026**
(21) Application number: 25215350.7
(22) Date of filing: 12.11.2025
(51) Int. Cl.: G05F 1/575, G11C 5/14, H02M 3/07

(54) **SUPPLY CONTROL CIRCUIT AND CORRESPONDING DEVICE**

(30) Priority: 02.12.2024 IT 202400027231
(71) Applicant: STMicroelectronics International N.V., 1228 Plan-les-Ouates, Geneva (CH)
(72) Inventor: RUTA, Marco, I-95027 San Gregorio di Catania (Catania) (IT); TOMAIUOLO, Francesco, I-95024 Acireale (Catania) (IT); CONTE, Antonino, I-95030 Tremestieri Etneo (Catania) (IT); BUONO, Luigi, I-95030 Gravina di Catania (Catania) (IT)
(74) Representative: Buzzi, Notaro & Antonielli d'Oulx S.p.A.

(57) **Abstract**

A circuit configured to supply a load at an output node (vout) comprises driver circuitry including voltage boost capacitive circuitry (C_{1A}, C_{1B}, C_{2A}, C_{2B}) configured to apply to the control terminals (B₁, C₁, B₂, C₂) of one or more driver transistors (M_{DPV_1A}, M_{CASC_2A}, M_{DRV_1B}, M_{CASC_2B}) a voltage-pumped (100B, vbl_boost_var) replica of the comparison signal (COMP_OUT) between a reference voltage and a voltage that is a function of the output voltage (vout). Voltage refresh transistor circuitry (M_{1A}, M_{2A}, M_{1B}, M_{2B}) coupled to the voltage boost capacitive circuitry (C_{1A}, C_{1B}, C_{2A}, C_{2B}) is configured to transfer thereon the voltage-pumped (100B, vbl_boost_var) replica of the comparison signal (COMP_OUT). The driver circuitry is controllably (PA_LV, PB_LV) switchable between a first mode of operation during which the current flow path therethrough is conductive or non-conductive in response to the voltage-pumped (100B, vbl_boost_var) replica of the comparison signal (COMP_OUT) while the voltage refresh transistor circuitry (M_{1A}, M_{2A}, M_{1B}, M_{2B}) is de-activated, and a second mode of operation during which the voltage refresh transistor circuitry (M_{1A}, M_{2A}, M_{1B}, M_{2B}) is activated and the current flow path through the driver circuitry (M_{DRV_1A}, M_{CASC_2A}, M_{DRV_1B}, M_{CASC_2B}) is non-conductive.

The circuit comprises variable boosted voltage generation circuitry (1000, 200, 202, 204) sensitive to a supply voltage at a supply node and configured to produce a variable boosted voltage (vbl_boost_var) wherein the variable boosted voltage generation circuitry (200, 202) is configured to increase the variable boosted voltage (vbl_boost_var) in response to a decrease of the supply voltage at the supply node

## Description

### Technical field

The description relates to controlling supply sources.

One or more embodiments can be applied, for instance, in converters such as Low Drop-Out (LDO) regulators.

### Description of the related art

Regulators currently referred to as Low Drop-Out (LDO) regulators are exemplary of DC voltage regulator circuits that can operate even when the supply voltage is very close to the output voltage.

Such regulator circuits are generally designed to provide fixed output voltages over varying loads with minimal voltage dropout and (very) fast response times.

They are widely used in industrial and automotive applications.

The ever-increasing demand for portable and battery-operated products benefits from such regulator circuits being capable of operating over a wide range of supply voltages and/or in multi-voltage platforms, for instance with a voltage currently referred to as vcc (voltage used to supply high-voltage transistors) in the range [1.6V-3.6V] or a voltage currently referred to as vdd (voltage used to supply low-voltage transistors) in the range [0.8V-1.15V]).

Output drivers intended for use in these regulators should be able to provide a desired current in the worst case (for vcc as low as 1.6V). As a consequence, in case of a high vcc, the current provided by the drivers may be much higher, and thus the peak currents on the vcc supply line may be undesirably high.

Microcontroller applications benefit from controlled peak currents, and reducing disturbance on analog components due to high peak currents is desirable.

### Object and summary

An object of one or more embodiments is to contribute in addressing the issues outlined in the foregoing.

According to one or more embodiments, such an object can be achieved via a circuit having the features set forth in the claims that follow.

One or more embodiments may relate to a corresponding system.

One or more embodiments may relate to a corresponding method.

The claims are an integral part of the technical teaching provided herein in respect of the embodiments.

In solutions as described herein, a voltage that controls a cascode of the output driver is made variable instead of fixed. In that way, that voltage can be reduced in response to a voltage such as vcc being high
- thus reducing the peak currents produced - and increased in response to a voltage such as vcc being low
- thus producing an adequate output current from the driver.

In solutions as described herein peak currents from supply sources (vcc, for instance) can be controlled independently, with response times of an output driver rendered independent of vcc, with a reduced overshoot on the regulated voltage when vcc is high.

### Brief description of the annexed figures

One or more embodiments will now be described, by way of example only, with reference to the annexed figures, wherein:
Figure 1 is an exemplary block diagram of a power supply arrangement wherein current control circuitry as described herein can be applied;
Figure 2 is a diagram exemplary of possible different values assumed by signals which may occur in conventional power supply circuitry;
Figure 3 is a diagram exemplary of possible different values assumed by signals which may occur in power supply circuitry as proposed herein;
Figure 4 illustrates an exemplary form of implementation of peak current control circuitry as proposed herein;
Figure 5 is a diagram exemplary of possible different values assumed by signals which may occur in power supply circuitry as illustrated in Figure 4; and
Figure 6 illustrates how peak current control circuitry as described herein can be included in a power supply essentially as illustrated in Figure 1.

The figures are drawn to clearly illustrate the relevant aspects of the embodiments and are not necessarily drawn to scale.

The edges of features drawn in the figures do not necessarily indicate the termination of the extent of the feature.

### Detailed description of exemplary embodiments

In the ensuing description, one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment.

Moreover, particular configurations, structures, or characteristics may be combined in any adequate way in one or more embodiments.

The headings/references used herein are provided merely for convenience and hence do not define the extent of protection or the scope of the embodiments.

Unless the context indicates otherwise, like parts or elements are indicated throughout the figures annexed herein with like references/numerals and a corresponding description will not be repeated for the sake of brevity.

For the sake of simplicity and ease of explanation, a same designation may be applied throughout this description to designate:
a certain node or line as well as a signal occurring at that node or line;
a certain component (such as a capacitor, resistor or inductor of coil) as well as electrical parameters thereof.

Also, when it is mentioned that an element is "connected to" or "coupled to" another element, it should be understood that still another element may be interposed therebetween, as well as that the element may be connected or coupled directly to another element.

On the contrary, when it is possibly mentioned that an element is "connected directly to" or "coupled directly to" another element, it should be understood that still another element is not interposed therebetween.

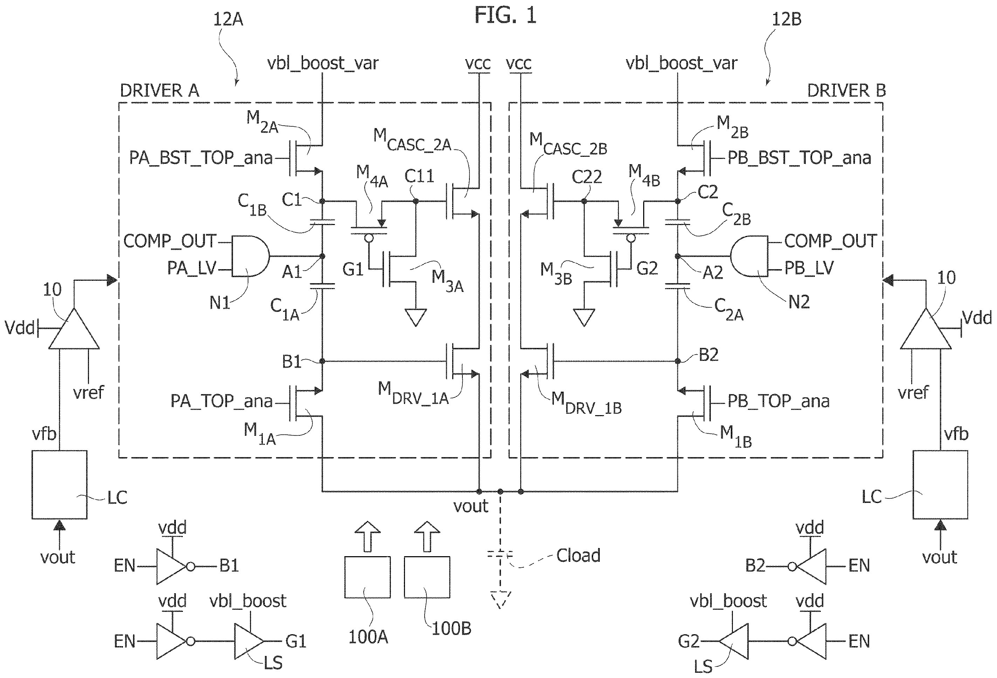

By way of background, Figure 1 is a circuit diagram substantially corresponding to the solution disclosed in document EP 4 261 651 A1 (and the corresponding U.S. publication US 2023/333583 A1), namely an LDO regulator circuit that comprises an input comparator as well as driver circuitry including transistors having a current flow path therethrough coupled to an output node vout of the regulator.

Reference may thus be had for further information to those earlier documents.

To summarize, the circuit illustrated in Figure 1 comprises two symmetrical drivers 12A (DRIVER A) and 12B (DRIVER B) configured to co-operate within the framework of a LDO regulator that comprises:
a comparator (error amplifier) 10 - for ease of representation and explanation, this is indicated twice at those nodes where a signal COMP_OUT is injected into the drivers 12A and 12B) - supplied at a voltage vdd and configured to compare a (feedback) voltage vfb with a stable reference voltage vref (a bandgap reference, for instance). The voltage vfb is derived via a loop control network LC from an output voltage vout of the regulator (e.g., as a fraction of the output voltage sensed via a voltage divider);
a phase generator 100A that, starting from a refresh clock (from a source not visible for simplicity), generates various drive signals PA_LV, PB_LV, PA, PB to manage different operation phases of the drivers 12A (DRIVER A) and 12B (DRIVER B), and
a boost pump 100B: this is a small charge pump that, starting from the signal vout and the signals PA, PB generates a "boosted" output voltage vbl_boost = vdd + vout plus various other signals PA_TOP_ana, PA_BST_TOP_ana, PB_TOP_ana, PB_BST_TOP_ana to drive the drivers DRIVER A and DRIVER B as discussed in the following.

The phase generator 100A and the boost pump 100B are illustrated as mutually distinct elements that are also distinct from the drivers 12A and 12B; this is merely by way of example in so far as in certain examples these elements can be mutually integrated and/or integrated with the drivers 12A and 12B.

As illustrated in Figure 1, the drivers 12A (DRIVER A) and 12B (DRIVER B) are symmetrical and co-operate in producing an output voltage vout starting from the low-voltage signal COMP_OUT from the comparator 10.

It is otherwise noted that the solutions proposed herein are intended to address issues that are related primarily to the circuit structure of the individual drivers 12A and 12B and to the alternate mode of operation of each of them rather than to the possible presence of both drivers in a circuit such as, for instance, a converter such as Low Drop-Out (LDO) regulators.

Solutions as proposed herein can therefore be applied also to circuits including even just one driver having the structure of the drivers 12A and 12B discussed herein and configured for an alternate mode of operation including a pulsing phase and a refresh phase (with a possible transition phase therebetween).

Various figures herein starting from Figure 1 are illustrative of a field-effect (MOSFET) implementation of the drivers 12A and 12B.

At least in principle, a bipolar junction transistor (BJT) implementation of the circuits discussed in the present description is possible. In such a BJT implementation, the control terminal will be the base of these transistors (in the place of the gate for a field-effect transistor) and the current path therethrough will be represented by the emitter-collector current flow path (in the place of source-drain current flow path for a field-effect transistor).

Various figures herein starting from Figure 1 are likewise illustrative of an implementation of the drivers 12A and 12B where voltages such as vcc or vdd are assumed to be positive voltages, with the polarities of the transistors (e.g., p-channel/n-channel MOSFETs) selected correspondingly. Those of skill in the art can easily devise corresponding adaptations of polarities in case voltages such as vcc or vdd are negative voltages.

Considering the driver 12A (DRIVER A) first, references M_{CASC_2A} and M_{DRV_1A} denote two transistors (two MOSFET transistors, for instance) arranged with the current flow paths therethrough (source-drain in the case of a field-effect transistor such as a MOSFET transistor) cascaded between a node at voltage vcc and the output node or line vout (this is common to the two drivers 12A and 12B and intended to be connected to a load such as, e.g., a capacitive load Cload, shown in phantom lines at the bottom of Figure 1).

The transistor M_{DRV_1A} is the main driver transistor and can be chosen as a low-voltage (LV) transistor.

In an implementation as illustrated, the source of the transistor M_{DRV_1A} is coupled to the output node vout and the gate coupled to a node B1 to be pulsed (shifted) from vout to vout + vdd when a pulse in the signal COMP_OUT comes from the comparator 10.

As noted, throughout this description, a same designation (e.g., vout, vdd) is used for brevity to designate a certain node or line as well as a signal occurring at that node or line.

Reference vout thus denotes the regulated voltage and vdd is a low voltage supply.

The transistor M_{CASC_2A} is a high-voltage (HV) transistor (MOSFET, for instance) that facilitates obtaining a cascoded signal on the drain of the transistor M_{DRV_1A} to facilitate protection thereof in various operating conditions.

The control electrode (gate, in the case of a field-effect transistors such as a MOSFET) C1 is pulsed (shifted) from vout + vdd to vout + 2vdd when a pulse in the signal COMP_OUT comes from the comparator 10.

As illustrated herein, the transistors M_{DRV_1A} and M_{CASC_2A} are "on" (conductive) during a pulsing phase as discussed in the following.

References C_{1A} and C_{1B} denote boost capacitors that are refreshed, during a refresh phase, to bring the node B1 to vout and a node C1 to a boost voltage.

The nodes C1 and B1 are arranged in a current flow line between a node at the boost voltage (which, for reasons to be discussed in the following, is referenced in Figure 1 as vbl_boost_var) and the output node vout, such a current flow line including the cascaded arrangement of:
a current flow path (source-drain in the case of a field-effect transistor such as a MOSFET) through a transistor M_{2A} arranged between the node at voltage vbl_boost_var and the node C1,
the capacitor C_{1B} between the node C1 and a node A1;
the capacitor C_{1A} between the node A1 and the node B1;
a current flow path (source-drain in the case of a field-effect transistor such as a MOSFET) through a transistor M_{1A} arranged between the node B1 and the output node vout.

The transistors M_{1A} and M_{2A} are used to refresh the capacitor C_{1A} (node B1) and the capacitor C_{1B} (node C1).

The control electrodes (gates in the case of field-effect transistors such as a MOSFET) of the transistors M_{1A} and M_{2A} receive from the boost pump 100B signals PA_TOP_ana and PA_BST_TOP_ana (at values vout + vdd and vout + 2vdd, respectively) to switch on (make conductive) the two transistors M_{1A} and M_{2A} during refresh phases as discussed in the following.

References M_{3A} and M_{4A} denote two further transistors (MOSFETs, for instance) arranged with:
the current flow-path (here, source-drain) through the transistor M_{3A} between the control electrode (here, gate) C11 of the cascode transistor MCASC_2A and a reference node (ground, for instance), and
the current flow-path (here, source-drain) through the transistor M_{4A} between the nodes C1 and C11 and the control electrode (here, gate) G1 coupled to the control electrode (here, gate) of the transistors M_{3A}.

The transistors M_{3A}, M_{4A} (n-channel and p-channel) are used to disconnect the node C11 from the node C1 and put it to ground in when the regulator, and so the output driver, is OFF (EN = 0). In OFF condition the nodes B1 and C11 are grounded.

An AND gate N1 provides gating of the signal COMP_OUT from the comparator 10 via a signal PA_LV that is "0" in a refresh condition (so that the signal COMP_OUT is don't care) and "1" in a pulsing condition.

Considering now the driver 12B (DRIVER B), references M_{CASC_2B} and M_{DRV_1B} denote two transistors (two MOSFET transistors, for instance) arranged with the current flow paths therethrough (source-drain in the case of a field-effect transistor such as a MOSFET transistor) cascaded between the node at voltage vcc and the output node or line vout (as noted, this is common to the two drivers 12A and 12B).

The transistor M_{DRV_1B} is the main driver transistor and can be chosen as a low-voltage (LV) transistor.

In an implementation as illustrated, the source of the transistor M_{DRV_1B} is coupled to the output node vout and the gate coupled to a node B2 to be pulsed (shifted) from vout to vout + vdd when a pulse in the signal COMP_OUT comes from the comparator 10.

The transistor M_{CASC_2B} is a high-voltage (HV) transistor (MOSFET, for instance) that facilitates obtaining a cascoded signal on the drain of the transistor M_{DRV_1B} to facilitate protection thereof in various operating conditions.

The control electrode (gate, in the case of a field-effect transistors such as a MOSFET) C2 is pulsed (shifted) from vout + vdd to vout + 2vdd when a pulse in the signal COMP_OUT comes from the comparator 10.

As illustrated herein, the transistors M_{DRV_1B} and M_{CASC_2B} are "on" (conductive) during a pulsing phase as discussed in the following.

References C_{2B} and C_{2A} denote boost capacitors that are refreshed, during a refresh phase, to bring the node B2 to vout and a node C2 to a boost voltage.

The nodes C2 and B2 are arranged in a current flow line between the node at the boost voltage and the output node vout, the current flow line including the cascaded arrangement of:
a current flow path (source-drain in the case of a field-effect transistor such as a MOSFET) through a transistor M_{2B} arranged between the node at the boost voltage (which, for reasons to be discussed in the following, is again referenced in Figure 1 as vbl_boost_var) and the node C2,
the capacitor C_{2B} between the node C2 and a node A2;
the capacitor C_{1B} between the node A2 and the node B2;
a current flow path (source-drain in the case of a field-effect transistor such as a MOSFET) through a transistor M_{1B} arranged between the node B2 and the output node vout.

The transistors M_{1B} and M_{2B} are used to refresh the capacitor C_{2A} (node B2) and the capacitor C2B (node C2).

The control electrodes (gates in the case of field-effect transistors such as a MOSFET) of the transistors M_{1B} and M_{2B} receive from the boost pump 100B signals PB_TOP_ana and PB_BST_TOP_ana (at values vout + vdd and vout + 2vdd, respectively) to switch on (make conductive) the two transistors M_{1B} and M_{2B} during refresh phases as discussed in the following.

References M_{3B} and M_{4B} denote two further transistors (MOSFETs, for instance) arranged with:
the current flow-path (here, source-drain) through the transistor M_{3B} between the control electrode (here, gate) C22 of the cascode transistor M_{CASC_2B} and a reference node (ground, for instance), and
the current flow-path (here, source-drain) through the transistor M_{4B} between the nodes C2 and C22 and the control electrode (here, gate) G2 coupled to the control electrode (here, gate) of the transistors M_{3B}.

The transistors M_{3B}, M_{4B} (n-channel and p-channel) are used to disconnect the node C22 from the node C2 and put it to ground in when the regulator, and so the output driver, is OFF (EN = 0). In OFF condition the nodes B2 and C22 are grounded

An AND gate N2 provides gating of the signal COMP_OUT from the comparator 10 via a signal PB_LV that is "0" in a refresh condition (so that the signal COMP_OUT is don't care) and '1' in a pulsing condition.

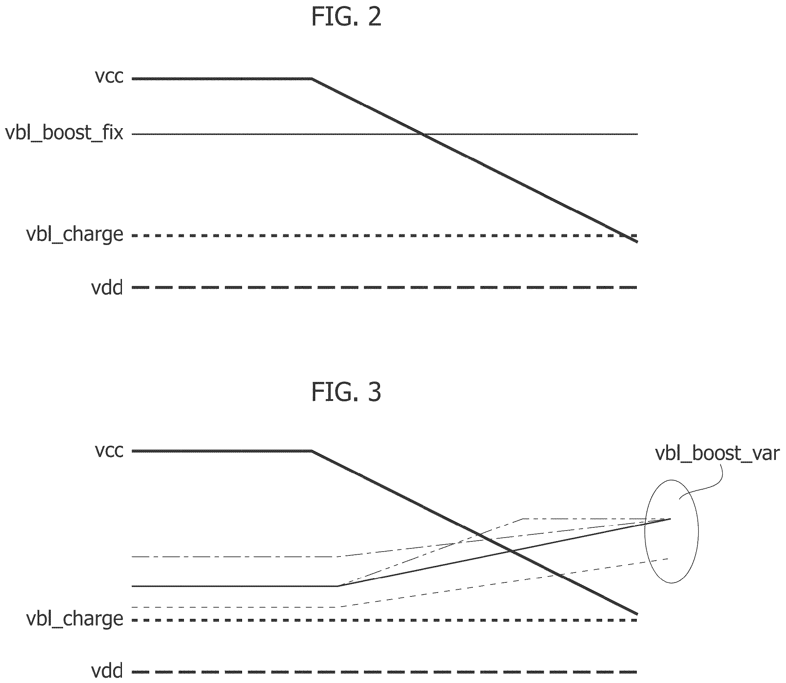

The bottom portion of Figure 1 provides - by way of immediate reference - an exemplary presentation of how the signals at nodes B1, G1, B2, and G2 can be obtained (asserted) based on a general enable signal EN, via an inverter referred to the node vdd (signal at the nodes B1 and B2) and via the cascaded arrangement of an inverter referred to the node vdd and a level shifter LS (of any known type for that purpose) referred to the the boost pump 100B of Figure 2 (signals at the nodes B2 and G2).

To summarize, the circuit illustrated in Figure 1 comprises at least one driver (the first driver 12A - DRIVER A and/or the second driver 12B - DRIVER B) each in turn comprising:
driver transistors M_{DRV_1A}, M_{CASC_2A}, M_{DRV_1B}, M_{CASC_2B} having current flow paths therethrough coupled to the output node vout;
capacitive boost circuitry C_{1A}, C_{1B}, C_{2A}, C_{2B} that applies to the drive transistors M_{DRV_1A}, M_{CASC_2A}, M_{DRV_1B}, M_{CASC_2B} a voltage-pumped replica of a comparison signal COMP_OUT;
voltage refresh transistor circuitry M_{1A}, M_{2A}, M_{1B}, M_{2B} coupled to the capacitive boost circuitry C_{1A}, C_{1B}, C_{2A}, C_{2B} to transfer thereon the voltage-pumped replica of the comparison signal COMP_OUT.

Each one of the first driver 12A and the second driver 12B can thus be controllably switched (via the signals PA_LV and PB_LV) between:
a first mode of operation, during which the current flow path through the driver transistors M_{DRV_1A}, M_{CASC_2A}, M_{DRV_1B}, M_{CASC_2B} is conductive or non-conductive based on the voltage-pumped replica of the comparison signal COMP_OUT, and
a second mode of operation, during which the voltage refresh transistor circuitry M_{1A}, M_{2A}, M_{1B}, M_{2B} coupled to the voltage boost capacitive circuitry C_{1A}, C_{1B}, C_{2A}, C_{2B}) is activated (via a signal ON) to transfer thereon the voltage-pumped replica of the comparison signal COMP_OUT, and the current flow path through the driver transistors M_{DRV_1A}, M_{CASC_2A}, M_{DRV_1B}, M_{CASC_2B} is non-conductive.

In an arrangement as illustrated in Figure 1 the drivers 12A (DRIVER A) and 12B (DRIVER B) in Figure 1 are two symmetrical parts of a circuit, intended to work essentially in an alternative (alternated) way: when one driver (12A, resp. 12B) is in a pulsing phase, the other driver (12B, resp. 12A) is in a refresh phase and vice versa. In fact, some sort of overlapping between the two is advantageously provided, with both drivers in the pulsing phase, to facilitate continuous regulation.

The block 100A is a phase generator that, starting from a refresh clock (generated in a manner know per se to those of skill in the art), produces adequate signals to manage the different phases of the main drivers.

The block 100B is a (small) boost pump configured to generate an output voltage vbl_boost = vdd + vout and boost signals to facilitate a correct refresh phase.

A solution as described so far in connection with Figure 1 essentially corresponds to EP 4 261 651 A1 and US 2023/333583 A1 - both already cited.

That solution was found to be largely satisfactory.

It was otherwise observed that such a solution can be further improved by resorting to a variable boost voltage - hence reference to vbl_boost_var in discussing Figure 1 - with a view to taking into account possible (large) variations in the supply voltage vcc as likely to occur in certain possible applications (microcontroller applications can be mentioned as a possible example).

By way of simple explanation, one may refer to the driver 12A and note the following (the same remarks apply - mutatis mutandis - to the driver 12B, which shares the same circuit architecture):
the transistor M_{DRV_1A} is the main driver and can be implemented as a low-voltage (LV) transistor; the source is at the output voltage vout and the gate B1 is pulsed from vout to vout + vdd when a pulse appears as the signal COMP_OUT while vout is the regulated voltage and vdd is a low-voltage supply [0.8V, 1.15V];
the transistor M_{CASC_2A} can be implemented as a high-voltage (HV) transistor to facilitate achieving a cascoded signal on the drain of the transistor M_{DRV_1A} for protection in various operating conditions: the gate C1 is pulsed from vout + vdd to vout + 2vdd when a pulse appears as the signal COMP_OUT;
the transistors M_{DRV_1A} and M_{CASC_2A} are "on" (conductive) during the pulsing phase;
the capacitors C_{1A} and C_{1B} are boost capacitors and are refreshed, during the refresh phase, via refresh voltages at the nodes B1 and C1;
the transistors M_{1A} and M_{2A} are used to refresh the boost capacitors with the signals PA_TOP_ana and PA_BST_TOP_ana at vout + vdd and vout + 2vdd, respectively to turn on (make conductive) the two transistors during the refresh phase;
the transistors M_{3A} and M_{4A} are used to disconnect the node C11 from the node C1 and set it to ground when the regulator, and so the output driver, is OFF (EN = 0); in such an OFF (inactive) condition both nodes B1 and C11 are grounded; and

PA_LV is "0" in a refresh condition (COMP_OUT is essentially "don't care") and "1" in a pulsing condition

Consequently, by referring essentially to the (alternate) behavior of the drivers 12A and 12B in an "on" condition of the regulator:
with the driver 12B (DRIVER B) in a pulsing phase, the transistors M_{DRV_1B} and M_{CASC_2B} will be switched on/off (made conductive/non-conductive) depending on the value of the signal COMP_OUT while the driver 12A (DRIVER A) will be in a refresh phase with the boost capacitors C_{1A} and C_{1B} charged via the transistors M_{1A} and M_{2A}; during the refresh phase of the driver 12A (DRIVER A), the gates of the transistors M_{1A} and M_{2A} are boosted by the signals PA_BST_TOP_ana with the node C11 at (vout + vdd) + vdd and the signal PA_TOP_ana with the node B1 at (vout) + vdd;
with the driver 12A (DRIVER A) in a pulsing phase, the transistors M_{DRV_1A} and M_{CASC_2A} will be switched on/off (made conductive/non-conductive) depending on the value of the signal COMP_OUT while the driver 12B (DRIVER B) will be in a refresh phase with the boost capacitors C_{2A} and C_{2B} charged via the transistors M_{1B} and M_{2B}; during the refresh phase of the driver 12B (DRIVER B), the gates of the transistors M_{1B} and M_{2B} are boosted by the signals PB_BST_TOP_ana with the node C22 at (vout + vdd) + vdd and the signal PB_TOP_ana with the node B2 at (vout) + vdd.

As noted previously, in various applications such as microcontroller applications (these are mentioned merely by way of non-limiting example) a supply voltage such as the voltage vcc may vary appreciably (from 3.6V to 1.6V, for instance).

In an arrangement as illustrated in Figure 1, the output drivers M_{DRV_1A} and M_{DRV_1B} can thus be sized with a view to providing a current as desired in the worst case, namely when vcc is as low as 1.6V, for instance (this value is merely exemplary and shall not be construed in a limiting manner).

As a consequence, in the presence of a higher values for the supply voltage vcc, the current provided by the drivers is (much) higher, which may result in undesirably high peak values of the current on a supply node/line at a voltage vcc. In turn such high peak currents may generate disturbance on analog circuitry, for instance.

For that reason, a control of peak currents from the voltage supply is a desirable feature in applications such as microcontroller applications.

Just by way of non-limiting reference, simulation of operation involving read operations and idle states between two consecutive reads shows a peak current of 80mA for a supply voltage vcc of 3.6V which decreases to 40mA for a supply voltage vcc of 1.9V.

In that respect, Figure 2 shows against a common abscissa scale the possible behavior of various signals, namely (from top to bottom - Figure 1 can be observed for immediate reference):
the supply voltage vcc;
the signal vbl_boost (which is assumed here to be constant, at a value vbl_boost_fix);
a signal vbl_charge that is essentially the output regulated voltage vout;
the signal vdd.

It is again noted that issues as discussed in the foregoing are related primarily to the structure of the drivers 12A and 12B and to the alternate mode of operation of each of these drivers as described previously rather than the possible presence of both drivers in a circuit such as, for instance, a converter such as Low Drop-Out (LDO) regulators.

For that reason, solutions as proposed herein can be applied also to circuits including even just one driver having the structure here illustrated in connection with the drivers 12A and 12B and configured for an alternate mode of operation including a pulsing phase and a refresh phase (with a possible transition phase therebetween).

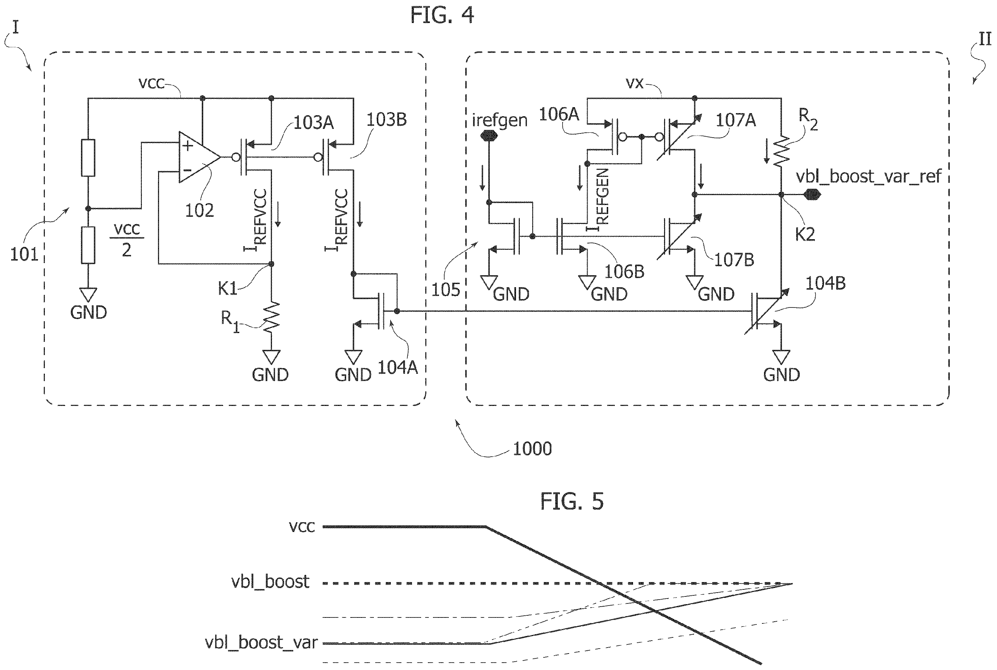

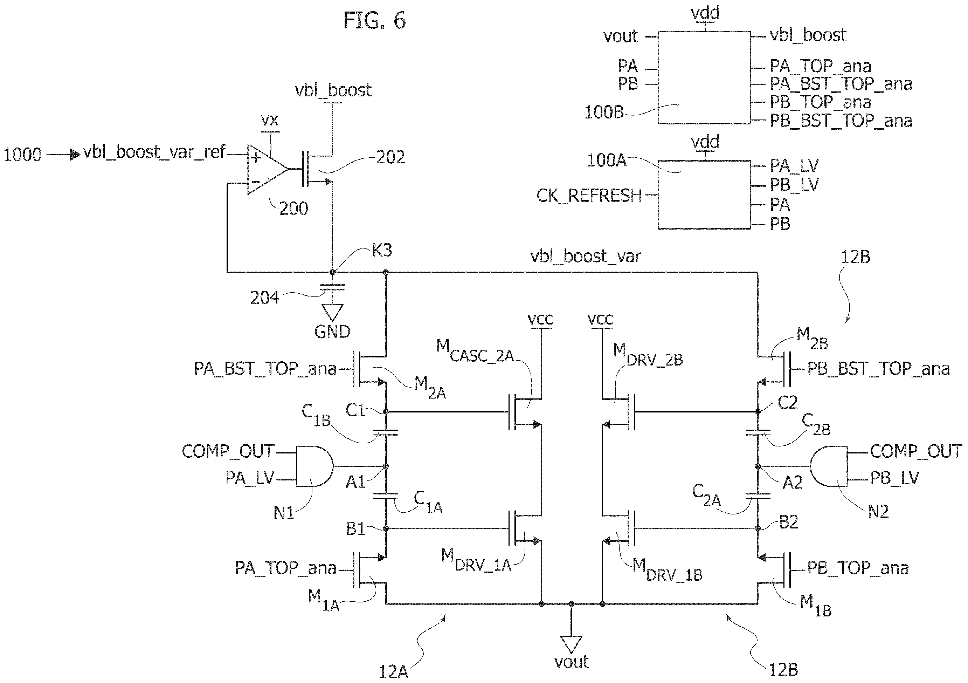

By way of comparison, Figure 3 shows against a common abscissa scale possible behaviors of the same signals (in addition to Figure 2, also Figure 1 can be again observed for immediate reference) in solutions as proposed herein, where a variable boost voltage vbl_boost_var is generated (via the circuitry illustrated in Figures 4 and 6 dissued in the following, for instance) that is no longer fixed as vbl_boost_fix in Figure 2 but is made variable, with different possible settings of the profile thereof represented in continuous line and in dashed lines.

In solutions as proposed herein, a variable value (vbl_boost_var in Figure 3) is provided that is increased in response to a decrease of the supply voltage vcc at the supply node, for instance by making the signal vbl_boost_var adjustable to be lower when vcc is high (to reduce the peak currents), and higher when vcc is low (to provide an adequate output current for driver operation).

Just by way of non-limiting example, solutions as proposed herein may lead to a reduction of peak current values from 80 mA (in the presence of a constant value vbl_boost_fix) to 30 mA (if a variable value vbl_boost_var is applied).

Figure 4 illustrates an exemplary form of implementation of circuitry 1000 configured to generate a signal vbl_boost_var_ref that can be used to produce a variable boost signal as exemplified by the curve vbl_boost_var in Figure 3.

Specifically, the exemplary circuitry 1000 illustrated in Figure 4 is configured to generate a (variable) reference value vbl_boost_var_ref that can be generated independently of the (fixed) value vbl_boost as generated by the boost pump 100B, for instance and used to generate a variable signal such as the signal vbl_boost_var in Figure 3: for instance, the signal vbl_boost_var can be just a replica of the signal vbl_boost_var_ref.

In the exemplary implementation of Figure 4 the circuitry indicated as 1000 as a whole can be regarded as including two stages I and II.

The stage I is supplied at a voltage vcc (the same reference is used as in Figure 1) and a voltage vcc/2 obtained therefrom via a resistive voltage divider 101 is applied to one input (non-inverting, for instance) of a comparator (error amplifier) 102 whose output drives the mutually coupled control terminals (gates, in the case of field-effect transistors such as MOSFETs as exemplified here) of two transistors 103A and 103B having current flow paths therethrough (source-drain, in the case of field-effect transistors such as MOSFETs as exemplified here) included in current flow lines between the supply node (rail) at voltage vdd and ground GND.

The current flow path through the transistor 103A is traversed by a current I_{REFVCC} and is coupled at a node K1 to a resistor R1 arranged between the transistors 103A and ground GND, with the (voltage) signal at the node K1 applied to the other input (inverting, for instance) of the comparator 102.

The current flow path through the transistor 103B is likewise traversed by a current I_{REFVCC} and is cascaded to the current flow path (source-drain, in the case of a field-effect transistor such as a MOSFET as exemplified here) through a further transistors 104A arranged between the transistors 103A and ground GND.

The (diode connected) transistor 104A is coupled in a current mirror arrangement (gate-to-gate in the case of field-effect transistors such as a MOSFETs as exemplified here) to a further transistor 104B in the stage II.

The stage II is supplied at a voltage vx (this can be regarded as a further supply line to the circuit) and includes a reference current generator irefgen (of any known type to those of skill in the art) active on a current flow path (source-drain, in the case of a field-effect transistor such as a MOSFET as exemplified here) through a (diode-connected) transistor 105 referred to ground GND.

The stage II includes various current flow paths arranged between the supply node (rail) at the voltage vx and ground GND.

A first current flow path is configured to be traversed by a current I_{REFGEN} through the cascaded arrangement of the current flow paths (source-drain, in the case of field-effect transistors such as MOSFETs as exemplified here) through a first (diode-connected) transistor 106A and a second transistor 106B arranged between the transistor 106A and a ground GND, with the control terminal (gate) of the transistor 106B coupled to the control terminal (gate) of the transistor 105 so that the current therethrough is mirrored as a current I_{REFGEN} in the current flow line through the transistors 106A and 106B.

A first further transistor 107A and a second further transistor 107B are arranged with their control terminals (gates, in the case of field-effect transistors such as MOSFETs as exemplified here) coupled to the control terminals of the transistors 106A and 106B, and respective current flow paths (source-drain, in the case of field-effect transistors such as MOSFETs as exemplified here) cascaded between the supply node (rail) at the voltage vx and ground GND.

It will be otherwise appreciated that, despite such cascaded arrangement, a current is not intended to flow from the transistor 107A to the transistor 107B.

In fact:
a resistor R2 is arranged between the supply node (rail) at the voltage vx and a (variable voltage) output node K2 where the voltage vbl_boost_var_ref is provided; and
the transistor 104B coupled in a gate-to-gate current mirror arrangement with the transistor 104A in the first stage I is arranged with the current flow path (source-drain, in the case of a field-effect transistor such as a MOSFET as exemplified here) therethrough between the output node K2 and ground GND.

In an arrangement as illustrated in Figure 4, current will flow:
from the transistor 107B to the resistor R2 to reduce (that is, move downwards) the voltage vbl_boost_var at the node K2; and
from the transistor 107A to the resistor R2 to increase (that is, move upwards) the voltage vbl_boost_var at the node K2.

Controlling the current on 107A and 107B facilitates controlling the amount by which the voltage vbl_boost_var at the node K2 is reduced/increased: the current flows through the resistor R2 via the transistor 104B and by varying the current it is possible to control the slope of change of the voltage vbl_boost_var.

That is, a node (line) K2 coupled:
intermediate the transistors 107A and 107B as well as
intermediate one end of the resistor R2 (having the other end coupled to the supply rail vx) and the current flow path through the transistor 104B (interposed between the node K2 and ground GND) provides the variable output voltage vbl_boost_war_ref whose value/behavior can be adjusted as desired acting on the transistors 107A, 107B and 104B: this is highlighted in Figure 4 by these transistors being depicted as "variable" components.

As discussed, in solutions as proposed herein a variable signal vbl_boost_var can be generated based on the signal vbl_boost_var_ref (advantageously implemented as exemplified in Figure 4) with different possible settings of the profile thereof represented in continuous line and in dashed lines.

This represents a possible implementation of a solution wherein a variable value vbl_boost_var can be generated, namely a value that can be varied, that is reduced when vcc is high to reduce the peak currents (and increased when vcc is low to provide an adequate output current for driver operation).

Figure 5 is a diagram exemplary of possible different values assumed by signals which may be applied to a power supply circuitry by resorting to the circuitry illustrated in Figure 4.

The representation for vbl_boost_var in full line and chain lines lines in Figure 5 shows that advantageous values for vbl_boost_var can be selected based on application specifications.

By way of non-limiting example:
in the presence of low values of vcc as low as 1.6V (which can be regarded as a worst-case condition - see the right-hand side of Figure 5) a value for vbl_boost_var can be selected such as to provide a desired current even in such a worst case; and
in the presence of higher values of vcc (which may lead to undesirably high peak current values - 80mA, for instance - see the left-hand side of Figure 5) a value for vbl_boost_var can be selected such as to reduce the peak current to a much lower value (30mA, for instance).

As noted, in solutions as described herein peak currents from supply sources can be controlled independently, with response times of an output driver rendered independent of vcc, with a reduced overshoot on the regulated voltage when vcc is high.

Figure 6 illustrates how peak current control circuitry as described herein can be included in a power supply arrangement essentially as illustrated in Figure 1. For simplicity and ease of explanation a detailed description of such power supply arrangement is not repeated here.

The right-hand portion of Figure 6 is a deliberately simplified representation of Figure 1 primarily intended to show:
how the (variable) signal vbl_boost_var can be applied to the current flow lines through the transistors M_{1A}, M_{2A} and M_{1B}, M_{2B}, and
how the (variable) signal vbl_boost_var can be generated based on a signal vbl_boost_var_ref (this can be generated via the circuitry 1000 exemplified in Figure 4, independently of the fixed value vbl_boost as generated by the boost pump 100B, which is again illustrated in Figure 6) applied to one input (non-inverting, for instance) of a comparator (error amplifier) 200 supplied via the same signal vx applied to the second stage II the circuitry 1000 previously discussed in connection with Figure 4.

The output from the error amplifier 200 drives the control terminal (gate, in the case of a field-effect transistor as exemplified) of a transistor 202 having the current flow path therethrough (source-drain in the case of a field-effect transistor as exemplified) arranged between a node/line at a (fixed) voltage vbl_boost from the boost pump 100B and a capacitor 204 that is between to current flow path through the transistor 202 (at a node K3) and ground GND.

The voltage at the node K3 is applied to the other input (inverting, for instance) of the error amplifier 200 and represents the variable signal vbl_boost_var applied to the current flow lines through the transistors M_{1A}, M_{2A} and M_{1B}, M_{2B}.

To summarize, the combination of the elements labeled 1000 (Figure 4) and 200, 202 (Figure 6) provides an example of variable boosted voltage generation circuitry configured to:
detect a decrease of the supply voltage vcc from a first value as visible from left to right in Figure 5;
set the variable boosted voltage vbl_boost_var to a value lower than the fixed reference value vbl_boost in response to the supply voltage vcc having a first value: this setting of vbl_boost_var lower than vbl_boost is represented at the left-hand side of Figure 5; and
increase the variable boosted voltage vbl_boost_var towards the value vbl_boost in response to the supply voltage vcc decreasing from the first (higher) value: this increase of vbl_boost_var lower is visible going from left to right in Figure 5, where one may further appreciate that the variable boosted voltage vbl_boost_var may be advantageously increase up to the value vbl_boost.

When implemented as exemplified in Figures 4 and 6, the variable boosted voltage generation circuitry includes a reference sensing stage (element 202) configured to receive the reference value vbl_boost plus boosted voltage correction circuitry (the circuit 1000 plus the elements 200 and 204) that are sensitive (see the elements 101, 102, 103A, 103B in Figure 4) to the supply voltage vcc and configured to apply the value vbl_boost_var_ref, possibly as a correction factor vbl_boost_var_ref that, as exemplified in Figure 4, is based on the supply voltage vcc.

As noted, the variable value vbl_boost_var_ref can be generated independently of the (fixed) value vbl_boost as generated by the boost pump 100B, and used to generate the variable signal vbl_boost_var in Figure 3: for instance, the signal vbl_boost_var can be just a replica of the signal vbl_boost_var_ref.

As illustrated in Figure 4, the comparator 102 can be configured to compare the supply voltage vcc with a scaled replica thereof (obtained via the voltage divider 101) so that a varying output from the comparator 102 is indicative in of a variation of the supply voltage vcc.

The transistors 104A and 104B are coupled in a current mirror arrangement including a first transistor 104A which is coupled (via the transistors 103A and 104B) to the comparator 102. A varying output from the comparator 102 thus produces a varying current in the first transistor 104A.

The second transistor 104B in the current mirror arrangement has a current flow path therethrough (source-drain in the case of a field-effect transistor as exemplified herein) coupled to the resistor R2 at the output node K2. In that way a varying current in the second transistor 104B produces a variable voltage vbl_boost_var_ref at the node K2.

In response to the current through the second transistor 104B mirroring the current through the first transistor 104A, a variable voltage vbl_boost_var_ref at the node K2 is thus indicative of a variation in the supply voltage vcc.

Operation of a circuit as schematically represented in the lower portion of Figure 6 may again comprise (as in the case of architecture as represented more in detail in Figure 1) alternately switching (via the signals PA_LV, PB_LV) each of the first 12A and second 12B drivers between:
a first operating condition wherein the first driver 12A is in the first mode of operation and the second driver 12B is in the second mode of operation, and
a second operating condition wherein the first driver 12A is in the second mode of operation and the second driver 12B is in the first mode of operation.

Advantageously, a transition operating condition can be contemplated wherein both the first driver 12A and the second driver 12B are in the first mode of operation, with the transition operating condition comprising discontinuing the second mode of operation in one of the first and second drivers de-activating the voltage refresh transistor circuitry therein while maintaining the other of the first and second drivers in the first mode of operation, wherein both the first driver and the second driver are in the first mode of operation, and discontinuing the first mode of operation in the other of the first and second drivers activating the voltage refresh transistor circuitry therein.

It is otherwise once more recalled that issues as discussed in the foregoing in connection with possible variations of the supply voltage vcc are related primarily to the structure of each driver 12A and 12B and the alternate mode of operation of each of them as described previously rather than the possible presence of both drivers in a circuit. Solutions as proposed herein are thus applicable to driver circuitry including even just one of the drivers 12A, 12B.

Without prejudice to the underlying principles, the details and embodiments may vary, even significantly, with respect to what has been described by way of example only without departing from the extent of protection.

The extent of protection is determined by the annexed claims.

## Claims

1. A circuit, comprising:
an output node (vout) configured to apply an output voltage to a load (Cload),
an input comparator (10) configured to perform a comparison of a reference voltage (vref) and a voltage (vfb) that is a function (LC) of the output voltage and to produce a comparison signal (COMP_OUT) having a first logical value or a second logical value based on the outcome of the comparison, and
driver circuitry (12A, 12B) coupled to the input comparator (10) to receive the comparison signal (COMP_OUT) therefrom, the driver circuitry comprising at least one driver transistor (M_{DRV_1A}, M_{CASC_2A}, M_{DRV_1B}, M_{CASC_2B}) having a current flow path therethrough coupled to the output node (vout) and a control terminal (B1, C1, B2, C2) configured to receive a voltage-pumped (100B; vbl_boost_var) replica of the comparison signal (COMP_OUT), wherein said replica of the comparison signal (COMP_OUT) has a first respective logical value or a second respective logical value based on the outcome of the comparison at the input comparator (10), wherein the current flow path through the least one driver transistor (M_{DRV_1A}, M_{CASC_2A}, M_{DRV_1B}, M_{CASC_2B}) is conductive or non-conductive in response to the voltage-pumped (100B; vbl_boost_var) replica of said comparison signal (COMP_OUT) having the first respective logical value or the second respective logical value,
wherein the driver circuitry (12A, 12B) comprises:
voltage boost capacitive circuitry (C_{1A}, C_{1B}, C_{2A}, C_{2B}) configured to apply to the control terminal (B₁, C₁, B₂, C₂) of the at least one driver transistor (M_{DRV_1A}, M_{CASC_2A}, M_{DRV_1B}, M_{CASC_2B}) said voltage-pumped (100B; vbl_boost_var) replica of the comparison signal (COMP_OUT),
voltage refresh transistor circuitry (M_{1A}, M_{2A}, M_{1B}, M_{2B}) coupled to the voltage boost capacitive circuitry (C_{1A}, C_{1B}, C_{2A}, C_{2B}) to transfer thereon said voltage-pumped (100B; vbl_boost_var) replica of the comparison signal (COMP_OUT),
wherein the driver circuitry (12A, 12B) is controllably (PA_LV, PB_LV) switchable between:
a first mode of operation during which the current flow path through the least one driver transistor (M_{DRV_1A}, M_{CASC_2A}, M_{DRV_1B}, M_{CASC_2B}) is conductive or non-conductive in response to the voltage-pumped (100B; vbl_boost_var) replica of said comparison signal (COMP_OUT) having the first respective logical value or the second respective logical value and the voltage refresh transistor circuitry (M_{1A}, M_{2A}, M_{1B}, M_{2B}) is de-activated, and
a second mode of operation during which the voltage refresh transistor circuitry (M_{1A}, M_{2A}, M_{1B}, M_{2B}) coupled to the voltage boost capacitive circuitry (C_{1A}, C_{1B}, C_{2A}, C_{2B}) is activated to transfer thereon said voltage-pumped (100B; vbl_boost_var) replica of the comparison signal (COMP_OUT), and the current flow path through the at least one driver transistor (M_{DRV_1A}, M_{CASC_2A}, M_{DRV_1B}, M_{CASC_2B}) is non-conductive,
wherein:
the current flow path through the at least one driver transistor (M_{DRV_1A}, M_{CASC_2A}, M_{DRV_1B}, M_{CASC_2B}) is included in a current flow line between a supply node at a supply voltage (vcc) and the output node (vout),
the voltage refresh transistor circuitry (M_{1A}, M_{2A}, M_{1B}, M_{2B}) comprises at least one refresh transistor (M_{1A}, M_{2A}, M_{1B}, M_{2B}) having a current flow path therethrough included in a current flow line between a boosted voltage line at a boosted voltage (vbl_boost_var) and the output node (vout), coupled to the output node (vout), and
the circuit comprises variable boosted voltage generation circuitry (1000; 200, 202, 204) sensitive to the supply voltage (vcc) at said supply node and configured to produce a variable boosted voltage (vbl_boost_var) at said boosted voltage line wherein the variable boosted voltage generation circuitry (1000; 200, 202, 204) is configured to increase said variable boosted voltage (vbl_boost_var) in response to a decrease of said supply voltage (vcc) at said supply node and to decrease said variable boosted voltage (vbl_boost_var) in response to an increase of said supply voltage (vcc) at said supply node.

2. The circuit of claim 1, wherein the variable boosted voltage generation circuitry (1000; 200, 202, 204) is configured to:
detect (102) decrease of said supply voltage (vcc) at said supply node from a first value;
set the variable boosted voltage (vbl_boost_var) to a value lower than a reference value (vbl_boost) in response to the supply voltage (vcc) having said first value; and
increase the variable boosted voltage (vbl_boost_var) towards said reference value (vbl_boost) in response to the supply voltage (vcc) decreasing from said first value.

3. The circuit of claim 2, wherein the variable boosted voltage generation circuitry (1000; 200, 202, 204) is configured to increase the variable boosted voltage (vbl_boost_var) up to said reference value (vbl _boost) in response to the supply voltage (vcc) decreasing from said first value.

4. The circuit of claim 2 or claim 3, wherein the variable boosted voltage generation circuitry (1000; 200, 202, 204) comprises:
a reference sensing stage (202) configured to receive a reference value (vbl_boost) for said boosted voltage; and
boosted voltage correction circuitry (1000, 200, 204) sensitive (101, 102, 103A, 103B) to the supply voltage (vcc) and configured to apply to said reference value (vbl _boost) a correction factor (vbl_boost_var_ref) based on said supply voltage (vcc).

5. The circuit of any of the previous claims, wherein the variable boosted voltage generation circuitry (1000; 200, 202, 204) comprises a comparator (102) configured to compare said supply voltage (vcc) with a scaled (101) replica thereof wherein a varying output from said comparator (102) is indicative of a variation of said supply voltage (vcc).

6. The circuit of claim 5, wherein:
the variable boosted voltage generation circuitry (1000; 200, 202) comprises a current mirror arrangement of a first transistor (104A) and a second transistor (104B),
the first transistor (104A) in the current mirror arrangement is coupled to the comparator (102), wherein a varying output from said comparator (102) produces a varying current in the first transistor (104A);
the second transistor (104B) in the current mirror arrangement has a current flow path therethrough coupled to a resistor (R2) at a variable voltage node (K2) wherein a varying current in the second transistor (104B) produces a variable voltage (vbl_boost_var) at said variable voltage node (K2), wherein said variable voltage (vbl_boost_var) at said variable voltage node (K2) is indicative of a variation in said supply voltage (vcc) in response to the current through the second transistor (104B) mirroring the current through the first transistor (104A) in the current mirror arrangement.

7. The circuit of any of the previous claims, wherein:
the driver circuitry comprises a first (12A) and a second (12B) driver coupled to the input comparator (10) to receive the comparison signal (COMP_OUT) therefrom and each of the first (12A) and second (12B) drivers comprises:
at least one driver transistor (MDRV_1A, MCASC_2A, MDRV_1B, MCASC_2B) having a current flow path therethrough coupled to the output node (vout) and a control terminal (B1, C1, B2, C2),
voltage boost capacitive circuitry (C1A, C1B, C2A, C2B) configured to apply to the control terminal (B1, C1, B2, C2) of the at least one driver transistor (MDRV_1A, MCASC_2A, MDRV_1B, MCASC_2B) said voltage-pumped (100B; vbl_boost_var) replica of the comparison signal (COMP_OUT),
voltage refresh transistor circuitry (M1A, M2A, M1B, M2B) coupled to the voltage boost capacitive circuitry (C1A, C1B, C2A, C2B) to transfer thereon said voltage-pumped (100B; vbl_boost_var) replica of the comparison signal (COMP_OUT),
wherein the first (12A) and second (12B) drivers are controllably (PA_LV, PB_LV) switchable between said a first mode of operation and said second mode of operation and the circuit comprises mode control circuitry (100A) configured (PA_LV, PB_LV) to alternately switch the first (12A) and second (12B) drivers between:
a first operating condition wherein the first driver (12A) is in the first mode of operation and the second driver (12B) is in the second mode of operation, and
a second operating condition wherein the first driver (12A) is in the second mode of operation and the second driver (12B) is in the first mode of operation.

8. The circuit of claim 7, wherein the mode control circuitry (100A) is configured (PA_LV, PB_LV) to switch the first (12A) and second (12B) drivers to a transition operating condition wherein both the first driver (12A) and the second driver (12B) are in the first mode of operation.

9. The circuit of claim 7 or claim 8, wherein the circuit comprises a Low Drop-Out (LDO) regulator.

10. A device comprising:
a circuit according to any of the preceding claims, and
an electrical load (Cload) coupled to said output node (vout) in the circuit to receive a regulated voltage therefrom.
